# EUROPÄISCHE PATENTANMELDUNG

(11) **EP 2 573 204 A1**
(43) Veröffentlichungstag der Anmeldung: **27.03.2013**
(21) Anmeldenummer: 12185005.1
(22) Anmeldetag: 19.09.2012
(51) Int. Cl.: C23C 14/04, C23C 14/56, C23C 14/58, C03C 17/09, F24C 15/10, F24C 7/08

(54) **Verfahren zur Herstellung einer Hausgeräteplatte**

(30) Priorität: 26.09.2011 ES 201131548
(71) Anmelder: BSH Bosch und Siemens Hausgeräte GmbH, 81739 München (DE)
(72) Erfinder: Alaman Aguilar, Jorge, 50008 Zaragoza (ES); Buñuel Magdalena, Miguel Angel, 50017 Zaragoza (ES); Cuartielles Ruiz, Diego, 50012 Zaragoza (ES); Ester Sola, Francisco Javier, 50001 Zaragoza (ES); Garcia Jimenez, Jose-Ramon, 86316 Friedberg (DE); Martin Gomez, Damaso, 20012 Zaragoza (ES); Perez Cabeza, Pilar, 50008 Zaragoza (ES); Planas Layunta, Fernando, 50009 Zaragoza (ES); Romeo Velilla, Rosario, 50008 Zaragoza (ES)

(57) **Zusammenfassung**

Die Erfindung geht aus von einem Verfahren zur Herstellung einer Hausgeräteplatte, bei dem wenigstens ein Teilbereich (21) einer Rohplatte (10) einer Wärmebehandlung (110) unterzogen wird.

Um ein gattungsgemäßes Verfahren zu verbessern, wird vorgeschlagen, dass vor der Wärmebehandlung (110) eine Oberflächenbeschichtung (112) zumindest eines Oberflächenteilbereichs (12) der Rohplatte (10) mit einer Schicht (14) mittels einer physikalischen Gasphasenabscheidung (114) durchgeführt wird.

## Beschreibung

Die Erfindung geht aus von einem Verfahren zur Herstellung einer Hausgeräteplatte nach dem Oberbegriff des Anspruchs 1.

Aus der DE 10 2004 053 707 A1 ist ein Verfahren zur Herstellung einer Hausgeräteplatte bekannt, bei der eine Rohplatte einer Wärmebehandlung unterzogen wird.

Die Aufgabe der Erfindung besteht insbesondere darin, ein gattungsgemäßes Verfahren zu verbessern. Die Aufgabe wird erfindungsgemäß durch die kennzeichnenden Merkmale des Anspruchs 1 gelöst, während vorteilhafte Ausgestaltungen und Weiterbildungen der Erfindung den Unteransprüchen entnommen werden können.

Die Erfindung geht aus von einem Verfahren zur Herstellung einer Hausgeräteplatte, bei dem wenigstens ein Teilbereich einer Rohplatte einer Wärmebehandlung unterzogen wird.

Es wird vorgeschlagen, dass vor der Wärmebehandlung eine Oberflächenbeschichtung zumindest eines Oberflächenteilbereichs der Rohplatte mit einer Schicht mittels einer physikalischen Gasphasenabscheidung durchgeführt wird. Unter einer "Hausgeräteplatte" soll in diesem Zusammenhang insbesondere eine Platte eines Hausgeräts und vorzugsweise eine Abdeckplatte des Hausgeräts insbesondere zur Abdeckung wenigstens einer Funktionseinheit des Hausgeräts verstanden werden. Vorzugsweise handelt es sich bei dem Hausgerät um ein Kochfeld, wobei die Hausgeräteplatte als eine Kochfeldplatte ausgebildet ist. Unter einer "Platte" soll hier und im Folgenden insbesondere ein räumliches Element verstanden werden, welches, in einer Abwicklung in einer Ebene betrachtet, in einem Querschnitt senkrecht zur Ebene eine unrunde Querschnittsfläche aufweist und senkrecht zur Ebene, von einzelnen Ausnehmungen, insbesondere durchgehenden Löchern und/oder Sacklöchern, abgesehen, eine insbesondere zumindest im Wesentlichen gleichbleibende Materialstärke aufweist, die weniger als 50 %, vorzugsweise weniger als 25 % und besonders bevorzugt weniger als 10 % einer Erstreckung des räumlichen Elements parallel zur Ebene, insbesondere einer kleinsten Erstreckung des Elements parallel zur Ebene, beträgt. Unter einer "Rohplatte" soll in diesem Zusammenhang insbesondere eine Platte verstanden werden, die insbesondere als Ausgangsplatte für die Herstellung der Hausgeräteplatte dient und die vorzugsweise während der Herstellung der Hausgeräteplatte bearbeitet wird. Vorzugsweise stellt die Rohplatte nach einer Fertigstellung der Hausgeräteplatte eine Grundplatte der Hausgeräteplatte dar. Vorzugsweise liegt in der Rohplatte zumindest im Wesentlichen eine amorphe Phase vor. Vorzugsweise besteht die Rohplatte zumindest teilweise und vorzugsweise vollständig aus einem Grünglas, insbesondere einem Ausgangsmaterial für eine Glaskeramik. Unter einer "Grundplatte" der Hausgeräteplatte soll in diesem Zusammenhang insbesondere eine Platte verstanden werden, welche insbesondere bei der Herstellung der Hausgeräteplatte aus wenigstens einem Teilbereich der Rohplatte hervorgeht und welche vorzugsweise eine Halteeinheit für weitere Elemente der Hausgeräteplatte darstellt. Insbesondere sind alle Elemente der Hausgeräteplatte in wenigstens einem betriebsbereiten Zustand des Hausgeräts zumindest indirekt durch die Grundplatte getragen. Vorzugsweise besteht die Grundplatte, insbesondere bei einer Verwendung als Kochfeldplatte, zumindest teilweise und vorzugsweise vollständig aus einer Glaskeramik. Vorzugsweise besteht die Grundplatte, insbesondere bei einer Verwendung als Backofenglas, zumindest teilweise und vorzugsweise vollständig aus Borosilikatglas.

Unter einem "Oberflächenteilbereich" der Rohplatte soll insbesondere ein Bereich einer Oberfläche der Rohplatte verstanden werden. Vorzugsweise erstreckt sich der Oberflächenteilbereich über eine gesamte von Kanten begrenzte Fläche der Rohplatte, insbesondere über eine größte und/oder zweitgrößte von Kanten begrenzte Fläche der Rohplatte. Unter einer "Oberflächenbeschichtung" soll insbesondere ein Oberflächenbeschichtungsverfahren verstanden werden. Unter einer "Schicht" soll hier und im Folgenden insbesondere ein räumliches Element verstanden werden, das an eine Form einer Oberfläche der Rohplatte und/oder der Grundplatte angepasst ist und insbesondere eine maximale Dicke aufweist, welche kleiner ist als eine minimale Dicke der Rohplatte und insbesondere der Grundplatte. Die maximale Dicke der Schicht beträgt vorzugsweise zumindest 20 nm. Die maximale Dicke beträgt vorzugsweise höchstens 100 nm. Bei der Schicht handelt es sich vorzugsweise um eine metallische Schicht, die besonders vorteilhaft Edelstahl aufweist. Unter einer "metallischen" Schicht soll insbesondere eine Schicht verstanden werden, welche zumindest eine metallische Eigenschaft aufweist. Die Menge der "metallischen Eigenschaften" umfasst hierbei insbesondere eine elektrische Leitfähigkeit von zumindest 10⁵ S/m bei 27°C, eine Wärmeleitfähigkeit von wenigstens 10 W/m/K bei 27°C und Spiegelglanz. Unter einer "physikalischen Gasphasenabscheidung" soll insbesondere ein vakuumbasiertes Oberflächenbeschichtungsverfahren verstanden werden, bei dem mittels physikalischer Verfahren ein Ausgangsmaterial in eine Gasphase überführt und anschließend zum zu beschichtenden Substrat geführt wird, wo es kondensiert und/oder adsorbiert wird und eine Zielschicht bildet.

Unter einer "Wärmebehandlung" eines Teilbereichs der Rohplatte soll insbesondere ein Verarbeitungsschritt der Herstellung der Hausgeräteplatte verstanden werden, bei dem der Teilbereich der Rohplatte wenigstens einmal erhitzt wird, insbesondere auf eine Temperatur von wenigstens 400°C, insbesondere von zumindest 500°C, vorzugsweise von mindestens 600°C und besonders vorteilhaft auf wenigstens 700°C. Vorzugsweise finden während der Wärmebehandlung wenigstens eine Abkühlung und zumindest ein weiteres Erhitzen des Teilbereichs der Rohplatte statt. Vorzugsweise umfasst der Teilbereich die gesamte Rohplatte. Vorzugsweise finden während der Wärmebehandlung eine Keramisierung der Rohplatte und besonders vorteilhaft eine wenigstens teilweise Kristallisation der Rohplatte statt. Vorzugsweise wird auch die Schicht der Wärmebehandlung unterzogen. Vorzugsweise wird mit der Wärmebehandlung gleichzeitig ein Einbrand eines Glasflusses vorgenommen, der insbesondere zu Markierungs- und/oder Dekorationszwecken auf die Rohplatte aufgebracht sein kann. Vorteilhaft wird die Wärmebehandlung des Teilbereichs der Rohplatte möglichst lange hinausgezögert.

Durch eine solche Ausgestaltung kann ein Verfahren zur Herstellung einer Hausgeräteplatte vorteilhaft verbessert werden. Insbesondere kann eine Steigerung einer Produktivität und einer Effektivität ermöglicht werden. Ferner kann eine vorteilhaft erhöhte Qualität und Reproduzierbarkeit bei der Herstellung der Hausgeräteplatte erreicht werden. Insbesondere kann vorteilhaft eine sehr geringe Dicke der Schicht erzielt werden. Ferner kann eine vorteilhaft hohe Flexibilität bei einer Wahl von Materialien der Schicht ermöglicht werden. Des Weiteren kann durch die Wärmebehandlung nach der Oberflächenbeschichtung eine Kristallstruktur der Schicht vorteilhaft variiert werden. Durch die Wärmebehandlung kann insbesondere eine Anpassung von optischen Eigenschaften der Schicht erfolgen.

Vorteilhaft wird die Schicht durch eine Kathodenzerstäubung aufgebracht. Unter einer "Kathodenzerstäubung" soll insbesondere eine Oberflächenbeschichtung verstanden werden, bei der Atome und/oder Moleküle aus einem Festkörpertarget durch Beschuss mit energiereichen Ionen, vorzugsweise Edelgasionen, herausgelöst werden, in die Gasphase übergehen und auf dem zu beschichtenden Werkstück angelagert werden. Hierdurch können vorteilhaft große Oberflächen mit einer insbesondere relativ dünnen Schicht versehen werden. Ferner kann eine hohe Flexibilität erreicht werden, da insbesondere viele verschiedene Materialien und Kombinationen von Materialien verwendet werden können. Des Weiteren können optische Eigenschaften der Schicht vorteilhaft durch eine Anpassung einer Kristallstruktur der Schicht verändert werden.

Ferner wird vorgeschlagen, dass nach der Oberflächenbeschichtung des Oberflächenteilbereichs ein Zuschnitt der Rohplatte auf eine gewünschte Größe vorgenommen wird. Unter einem "Zuschnitt der Rohplatte auf eine gewünschte Größe" soll insbesondere eine Aufteilung der Rohplatte in mehrere, insbesondere gleich große, Einzelstücke der gewünschten Größe verstanden werden. Vorzugsweise erfolgt der Zuschnitt durch einen Schneidvorgang. Vorzugsweise entspricht die gewünschte Größe einer typischen Größe für Kochfeldplatten oder Backofenscheiben. Insbesondere kann der Zuschnitt der Rohplatte vor oder nach der Wärmebehandlung der Rohplatte erfolgen. Besonders vorteilhaft wird der Zuschnitt der Rohplatte jedoch möglichst lange hinausgezögert. Hierdurch können eine Produktivität und eine Effektivität vorteilhaft gesteigert werden. Ferner kann eine vorteilhaft erhöhte Qualität und Reproduzierbarkeit bei der Herstellung der Hausgeräteplatte ermöglicht werden, insbesondere da Vorrichtungen zur Durchführung einer physikalischen Gasphasenabscheidung, insbesondere einer Kathodenzerstäubung, dazu ausgelegt sind, Rohplatten einer Mindestgröße von ungefähr 3 m × 3 m aufzunehmen. Ferner kann eine Automatisierung, insbesondere eines Einbringens der Rohplatte in die Vorrichtung, ermöglicht werden, wodurch Fehler, Materialbeschädigungen und/oder Materialverschmutzungen minimiert und eine Reproduzierbarkeit vorteilhaft erhöht werden können. Des Weiteren können Herstellungsdauer und Herstellungskosten gesenkt werden. Insbesondere kann vorteilhaft eine Grundplatte mit wenigstens einer unbeschichteten Stirnfläche bereitgestellt werden. Unter einer "Stirnfläche" einer Platte soll in diesem Zusammenhang insbesondere eine von Kanten begrenzte Fläche der Platte verstanden werden, deren Flächeninhalt höchstens 20 %, insbesondere höchstens 15 %, vorzugsweise höchstens 10 % und besonders vorteilhaft maximal 5 % eines Flächeninhalts einer größten von Kanten begrenzten Fläche der Platte beträgt.

In einer bevorzugten Ausgestaltung der Erfindung wird vorgeschlagen, dass zumindest ein Teilbereich der Schicht vor dem Zuschnitt der Rohplatte wenigstens einer Volumenbehandlung und/oder wenigstens einer Oberflächenbehandlung ausgesetzt wird. Insbesondere kann die Volumenbehandlung und/oder Oberflächenbehandlung des Teilbereichs der Schicht vor und/oder nach der Wärmebehandlung erfolgen. Unter einer "Volumenbehandlung" eines Bauteils soll insbesondere eine Bearbeitung des Bauteils verstanden werden, bei der das Bauteil eine zumindest wesentliche Änderung wenigstens einer Erstreckung und/oder einer Beschaffenheit, insbesondere eines Aufbaus und/oder eines Materials, in zumindest einem um mehr als 0,5 mm und insbesondere mehr als 1 mm von einer Außenoberfläche des Bauteils beabstandeten Bereich des Bauteils erfährt. Unter einer "Erstreckung" des Bauteils soll in diesem Zusammenhang insbesondere ein maximaler Abstand zweier Punkte einer senkrechten Projektion des Bauteils auf eine Ebene verstanden werden. Unter einer "zumindest wesentlichen Änderung einer Erstreckung und/oder einer Beschaffenheit" soll in diesem Zusammenhang insbesondere eine relative Änderung einer Kenngröße, insbesondere einer Erstreckung und/oder einer Porosität und/oder einer Materialzusammensetzung, um wenigstens 1 %, insbesondere um mindestens 5 %, vorzugsweise um wenigstens 10 % und besonders vorteilhaft um zumindest 15 % verstanden werden. Unter einer "Oberflächenbehandlung" eines Bauteils soll insbesondere eine Bearbeitung des Bauteils verstanden werden, bei der das Bauteil eine zumindest wesentliche Änderung einer Beschaffenheit, insbesondere eines Aufbaus und/oder eines Materials, in zumindest einem Bereich erfährt, dessen Punkte zu einer Außenoberfläche des Bauteils jeweils einen Abstand von höchstens 1 mm und insbesondere maximal 0,5 mm aufweisen, und/oder das Bauteil zumindest teilweise einer Oberflächenbeschichtung unterzogen wird. Unter einer "zumindest wesentlichen Änderung einer Beschaffenheit" soll in diesem Zusammenhang insbesondere eine relative Änderung einer Kenngröße, insbesondere einer Porosität und/oder einer Materialzusammensetzung, um wenigstens 1 %, insbesondere um mindestens 5 %, vorzugsweise um wenigstens 10 % und besonders vorteilhaft um zumindest 15 % verstanden werden.

Wenn die maximale Dicke der Schicht höchstens 100 nm beträgt, findet insbesondere lediglich eine Oberflächenbehandlung statt. Vorzugsweise umfasst die Oberflächenbehandlung des Teilbereichs der Schicht vor dem Zuschnitt der Rohplatte eine Laserbearbeitung, insbesondere eine Laserablation, zur Herstellung wenigstens eines Funktionsbereichs, insbesondere eines isolierten Bereichs für ein kapazitives berührungsempfindliches Bedienelement bei einer metallischen Schicht und/oder zur Verbesserung einer elektromagnetischen Verträglichkeit bei Induktionskochfeldern mit einer metallischen Schicht, und/oder zu Dekorationszwecken, insbesondere zur Markierung wenigstens einer Funktionszone, vorzugsweise einer Heizzone, und/oder zur Herstellung von Mustern, insbesondere zur Reduzierung eines Spiegelglanzes einer metallischen Schicht, und/oder eine Oberflächenbeschichtung des Teilbereichs der Schicht mit einer Schutzschicht. Unter einer "Laserbearbeitung" eines Werkstoffs soll in diesem Zusammenhang insbesondere eine Bearbeitung des Werkstoffs durch Einstrahlung von Laserlicht verstanden werden. Insbesondere führt die Einstrahlung des Laserlichts zu einer physikalischen Veränderung, insbesondere einem Verdampfen, und/oder einer chemischen Veränderung, insbesondere einer Oxidation oder Zersetzung, des Werkstoffs. Unter einer "Laserablation" soll insbesondere eine Laserbearbeitung verstanden werden, bei der ein durch Laserlicht bestrahlter Werkstoff abgetragen, insbesondere verdampft, wird. Unter einer "Schutzschicht" soll dabei insbesondere ein räumliches Element verstanden werden, das an eine Form einer von der Rohplatte abgewandten Oberfläche der Schicht angepasst ist und die Schicht vor chemischen und/oder thermischen und/oder mechanischen Einwirkungen schützt. Vorzugsweise verfügt die Schutzschicht über eine höhere chemische Beständigkeit in einem gegebenen Umfeld und/oder über eine höhere Temperaturbeständigkeit und/oder über eine höhere mechanische Belastbarkeit, insbesondere eine höhere Härte. Insbesondere kann die Schutzschicht eine dielektrische Farbschicht sein, die durch Ausnehmungen in der Schicht von einer von der Schicht abgewandten Seite der Rohplatte aus sichtbar ist. Hierdurch kann ein Herstellungsaufwand vorteilhaft reduziert werden. Ferner kann eine randlose Oberflächenbeschichtung der Schutzschicht, insbesondere mit einem Siebdruckverfahren, erreicht werden. Des Weiteren kann eine hohe Flexibilität in einer optischen Gestaltung der Hausgeräteplatte ermöglicht werden. Durch die Schutzschicht kann ein wirksamer Schutz der Schicht während der Herstellung der Hausgeräteplatte und insbesondere während des Zuschnitts der Rohplatte bereitgestellt werden. Durch ein Aufbringen der Schutzschicht vor dem Zuschnitt der Rohplatte kann die Effizienz und die Reproduzierbarkeit weiter vorteilhaft gesteigert werden.

In einer weiteren Ausgestaltung der Erfindung wird vorgeschlagen, dass zumindest ein Teilbereich der Rohplatte vor der Oberflächenbeschichtung des Oberflächenteilbereichs wenigstens einer Volumenbehandlung und/oder wenigstens einer Oberflächenbehandlung ausgesetzt wird. Insbesondere ist die Volumenbehandlung des Teilbereichs der Rohplatte vor der Oberflächenbeschichtung des Oberflächenteilbereichs von einer Herstellung der Rohplatte, insbesondere einer ersten Formung, insbesondere einem Walzen und/oder Floaten, der Rohplatte aus einer insbesondere teilweise flüssigen Glasschmelze und/oder einem unmittelbar anschließenden Zuschnitt verschieden. Vorzugsweise umfasst die Oberflächenbehandlung des Teilbereichs der Rohplatte vor der Oberflächenbeschichtung des Oberflächenteilbereichs eine Laserbearbeitung, insbesondere eine Laserablation, zur Herstellung von Aussparungen in einem Oberflächenbereich der Rohplatte, insbesondere im Oberflächenteilbereich, und/oder ein Bürsten einer Oberfläche, insbesondere des Oberflächenteilbereichs, zur Herstellung einer Anmutung von gebürstetem Stahl im Falle einer metallischen Schicht und/oder ein Reinigen und/oder Abtragen zur Herstellung eines Frosteffekts durch Strahlen, insbesondere Sandstrahlen und/oder Glasperlenstrahlen und/oder Schleuderradstrahlen und/oder Wasserstrahlen und/oder Mikrostrahlen, einer Oberfläche der Rohplatte, insbesondere des Oberflächenteilbereichs, und/oder eine Säurebehandlung einer Oberfläche der Rohplatte, insbesondere des Oberflächenteilbereichs zur Herstellung eines Staub- und/oder Nebeleffekts. Unter einem "Schleuderradstrahlen" soll in diesem Zusammenhang insbesondere eine Strahltechnik verstanden werden, bei der abrasive Strahlteilchen durch eine Zentrifugalkraft eines Schleuderrads gegen einen Werkstoff beschleunigt werden. Unter einem "Mikrostrahlen" soll insbesondere eine Strahltechnik verstanden werden, bei der Strahlteilchen mit einem Durchmesser von weniger als 150 µm durch eine Düse mit einem Durchmesser von höchstens 1,5 mm auf einen Werkstoff beschleunigt werden. Hierdurch kann eine vorteilhaft hohe Flexibilität in einer optischen Gestaltung der Hausgeräteplatte ermöglicht werden.

In einer besonders bevorzugten Ausgestaltung der Erfindung wird vorgeschlagen, dass wenigstens ein Teilbereich der Rohplatte nach der Oberflächenbeschichtung des Oberflächenteilbereichs wenigstens einer Volumenbehandlung und/oder wenigstens einer Oberflächenbehandlung ausgesetzt wird. Insbesondere können der Teilbereich und der Oberflächenteilbereich überlappen. Vorzugsweise wird der Teilbereich der Rohplatte nach dem Zuschnitt der Rohplatte der Volumenbehandlung und/oder der Oberflächenbehandlung ausgesetzt, wobei der Teilbereich insbesondere Stirnflächen der zugeschnittenen Teile der Rohplatte umfasst. Vorzugsweise umfasst die Volumenbehandlung des Teilbereichs der Rohplatte nach der Oberflächenbeschichtung des Oberflächenteilbereichs eine Formänderung der Rohplatte, insbesondere das Einarbeiten wenigstens einer Facette, insbesondere auf einer von der Schicht abgewandten Seite der Rohplatte, und/oder ein Abrunden wenigstens einer Ecke und/oder Kante und/oder Stirnfläche. Vorzugsweise umfasst die Oberflächenbehandlung des Teilbereichs der Rohplatte nach der Oberflächenbeschichtung des Oberflächenteilbereichs ein Schleifen und/oder Polieren wenigstens einer Oberfläche der Rohplatte und/oder ein Aufbringen zumindest eines Glasflusses, insbesondere mittels eines Siebdrucks, zur Herstellung wenigstens einer Markierung, insbesondere einer Funktionszone und vorzugsweise einer Heizzone. Hierdurch kann eine Herstellung der Hausgeräteplatte vorteilhaft vereinfacht werden. Ferner können Kosten reduziert werden.

Ferner wird eine Hausgeräteplatte, insbesondere eine Kochfeldplatte, vorgeschlagen, welche eine Grundplatte und eine an wenigstens einem Oberflächenteilbereich der Grundplatte angeordnete Schicht umfasst und welche durch ein erfindungsgemäßes Verfahren hergestellt ist. Hierdurch kann eine vorteilhaft kostengünstige, reproduzierbare und hochqualitative Hausgeräteplatte bereitgestellt werden.

Ferner wird vorgeschlagen, dass wenigstens eine Stirnfläche der Grundplatte unbeschichtet ist. Vorzugsweise sind alle Stirnflächen der Grundplatte unbeschichtet. Vorzugsweise handelt es sich bei der Stirnfläche um eine Schnittfläche, entlang der eine Trennung der Rohplatte beim Zuschnitt der Rohplatte vorgenommen wurde. Hierdurch kann, insbesondere bei einer metallischen Schicht, eine Betriebssicherheit erhöht werden, da eine Anfassbarkeit der metallischen Schicht in einem betriebsbereiten Zustand des Hausgeräts, insbesondere des Kochfelds, vorteilhaft vermieden werden kann.

Ferner wird vorgeschlagen, dass wenigstens ein Teilbereich der Schicht einer Wärmebehandlung unterzogen ist und/oder die Grundplatte zumindest wesentliche permanente thermisch induzierte mechanische Spannungen aufweist. Darunter, dass wenigstens ein Teilbereich der Schicht "einer Wärmebehandlung unterzogen ist", soll insbesondere verstanden werden, dass die Schicht und insbesondere auch deren Umgebung durch die Wärmebehandlung verändert wurde. Insbesondere kann durch die Wärmebehandlung eine mittlere Kristallitgröße in der Schicht im Vergleich zu einer unbehandelten Schicht zunehmen. Insbesondere tritt durch die Wärmebehandlung ein säulenartiges Kristallwachstum auf, insbesondere ausgehend von einer Kontaktfläche zwischen der Rohplatte und der Schicht. Ferner kann in Abhängigkeit von einem Material der Schicht eine Korrosion durch die Wärmebehandlung forciert werden. Ferner kann Material der Schicht während der Wärmebehandlung in die Rohplatte diffundieren und dann insbesondere in der Grundplatte nachweisbar sein, vorzugsweise mittels einer Glimmentladungsspektroskopie. Unter "zumindest wesentlichen permanenten thermisch induzierten mechanischen Spannungen" sollen insbesondere messbare permanente thermisch induzierte mechanische Spannungen verstanden werden, die insbesondere während der Wärmebehandlung durch unterschiedliche thermische Ausdehnungskoeffizienten der Rohplatte und der Schicht aufgetreten sind. Hierdurch kann eine vorteilhaft kostengünstig herstellbare Hausgeräteplatte bereitgestellt werden.

Ferner wird ein Hausgerät, insbesondere ein Kochfeld, mit einer erfindungsgemäßen Hausgeräteplatte vorgeschlagen. Vorzugsweise ist das Kochfeld als ein Induktionskochfeld ausgebildet.

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:

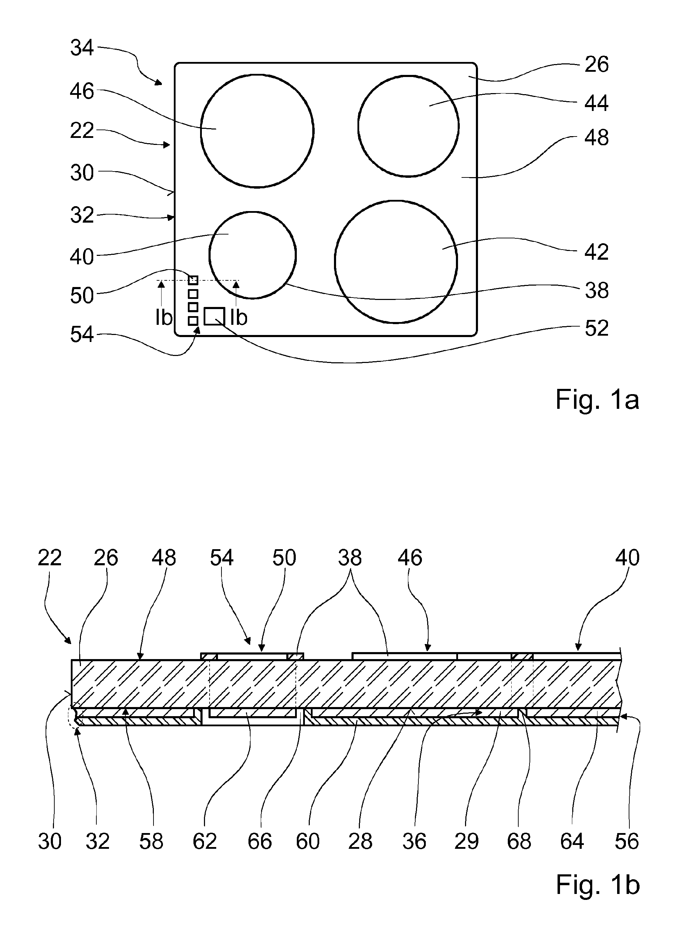

- Fig. 1 a: ein als Kochfeld ausgebildetes Hausgerät mit einer nach einem erfindungsgemäßen Verfahren hergestellten Hausgeräteplatte in einer Draufsicht,
- Fig. 1 b: einen Teil der Hausgeräteplatte in einer nicht maßstabsgetreuen Schnittdarstellung entlang einer Linie lb-lb in Fig. 1a,
- Fig. 2: ein Ablaufdiagramm des Verfahrens zur Herstellung der Hausgeräteplatte,
- Fig. 3a: einen Verfahrensschritt einer Variante des Verfahrens, in dem eine Rohplatte bearbeitet wird, in einer nicht maßstabsgetreuen isometrischen Darstellung,
- Fig. 3b: einen Verfahrensschritt der Variante des Verfahrens, in dem eine Schicht auf die Rohplatte aufgebracht wird, in einer nicht maßstabsgetreuen isometrischen Darstellung,
- Fig. 3c: einen Verfahrensschritt der Variante des Verfahrens, in dem eine Schutzschicht auf die Rohplatte aufgebracht wird, in einer nicht maßstabsgetreuen isometrischen Darstellung,
- Fig. 3d: einen Verfahrensschritt der Variante des Verfahrens, in dem ein Glasfluss auf die Rohplatte aufgebracht wird, in einer nicht maßstabsgetreuen isometrischen Darstellung,
- Fig. 3e: einen Verfahrensschritt der Variante des Verfahrens, in dem die Rohplatte zugeschnitten wird, in einer nicht maßstabsgetreuen isometrischen Darstellung,
- Fig. 3f: einen Verfahrensschritt der Variante des Verfahrens, in dem die Rohplatte abgerundet wird, in einer nicht maßstabsgetreuen isometrischen Darstellung,
- Fig. 4a: einen Verfahrensschritt einer weiteren Variante des Verfahrens, in dem die Rohplatte zugeschnitten wird, in einer nicht maßstabsgetreuen isometrischen Darstellung,
- Fig. 4b: einen Verfahrensschritt der weiteren Variante des Verfahrens, in dem die Rohplatte abgerundet wird, in einer nicht maßstabsgetreuen isometrischen Darstellung und
- Fig. 4c: einen Verfahrensschritt der weiteren Variante des Verfahrens, in dem auf die Rohplatte ein Glasfluss aufgebracht wird, in einer nicht maßstabsgetreuen isometrischen Darstellung.

Figur 1a zeigt ein als Kochfeld 34 ausgebildetes Hausgerät mit einer als Kochfeldplatte 22 ausgebildeten Hausgeräteplatte. Bei dem Kochfeld 34 handelt es sich um ein Induktionskochfeld. Die Kochfeldplatte 22 umfasst eine Grundplatte 26 aus einer Glaskeramik. Die Grundplatte 26 ist zumindest teilweise transparent. Die Kochfeldplatte 22 weist an einer Oberseite 48 Markierungen 38 auf, welche Heizzonen 40, 42, 44, 46 kennzeichnen. Obwohl die Markierungen 38, senkrecht zu einer Haupterstreckungsebene der Grundplatte 26 betrachtet, eine endliche Breite aufweisen, sind die Markierungen 38 in Fig. 1a vereinfachend lediglich als Linien eingezeichnet. Die Kochfeldplatte 22 ist in einem betriebsbereiten Zustand des Kochfelds 34 horizontal angeordnet und zu einem Aufstellen von Gargeschirr auf die Oberseite 48 der Grundplatte 26 und auf die Heizzonen 40, 42, 44, 46 vorgesehen. Unterhalb der Heizzonen 40, 42, 44, 46 sind in Fig. 1a nicht gezeigte Induktionsheizelemente angeordnet, welche zu einer Beheizung des auf die entsprechenden Heizzonen 40, 42, 44, 46 aufgestellten Gargeschirrs durch induzierte Wirbelströme vorgesehen sind. Durch die Markierungen 38 sind ferner Berühroberflächen 50 und eine Anzeigeeinheit 52 einer Bedien- und Anzeigeeinheit 54 des Kochfelds 34 gekennzeichnet.

Figur 1 b zeigt eine nicht maßstabsgetreue Schnittdarstellung der Hausgeräteplatte entlang einer Linie lb-lb in Fig. 1a. Die Grundplatte 26 weist an einem der Oberseite 48 gegenüberliegenden Oberflächenteilbereich 28 ein Schichtsystem 56 auf. Der Oberflächenteilbereich 28 erstreckt sich hierbei über eine gesamte Unterseite 58 der Grundplatte 26. Das Schichtsystem 56 umfasst eine Schicht 29. Die Schicht 29 ist metallisch. Durch die Schicht 29 entsteht eine metallische Anmutung der Kochfeldplatte 22. Die Schicht 29 weist eine Dicke von ungefähr 10 nm auf. Durch die relativ geringe Dicke, die lediglich einem Bruchteil der magnetischen Eindringtiefe eines durch die Induktionsheizelemente erzeugten Magnetfelds entspricht, kann eine negative Beeinträchtigung einer Heizwirkung des Magnetfelds auf das zu erwärmende Gargeschirr weitgehend vermieden werden. Auf einer von der Grundplatte 26 abgewandten Seite der Schicht 29 ist die Schicht 29 mit einer Schutzschicht 60 bedeckt. Bei der Schutzschicht 60 handelt es sich um eine dielektrische Farbschicht. Die Schicht 29 weist mehrere Teilstücke 62, 64 auf, welche über Isolierbereiche 66, 68 voneinander elektrisch isoliert sind. Bei den Isolierbereichen 66, 68 handelt es sich um Ausnehmungen in der Schicht 29. Diese Ausnehmungen sind mit Material der Schutzschicht 60 gefüllt. Das Teilstück 62 ist an der Unterseite 58 unmittelbar unterhalb der Berühroberfläche 50 angeordnet. Das Teilstück 62 stellt eine Elektrode für einen kapazitiven Näherungssensor der Bedien- und Anzeigeeinheit 54 dar. Das Teilstück 64 ist in einem betriebsbereiten Zustand betrachtet an der Unterseite 58 direkt oberhalb des entsprechenden Induktionsheizelements und unterhalb der Heizzone 40 angeordnet. Der das Teilstück 64 umschließende Isolierbereich 68 ist unmittelbar unterhalb der die Heizzone 40 kennzeichnende Markierung 38 angeordnet. Eine Breite des Isolierbereichs 68 ist senkrecht zu einer Haupterstreckungsebene der Grundplatte 26 betrachtet kleiner als die Breite der Markierung 38. Durch eine elektrische Entkopplung des Teilstücks 64 von der umgebenden Schicht 29 kann bei einem Betrieb des Induktionsheizelements eine Ausbreitung von im Teilstück 64 induzierten Wirbelströmen verhindert werden, wodurch eine elektromagnetische Verträglichkeit des Kochfelds 34 vorteilhaft gesteigert werden kann.

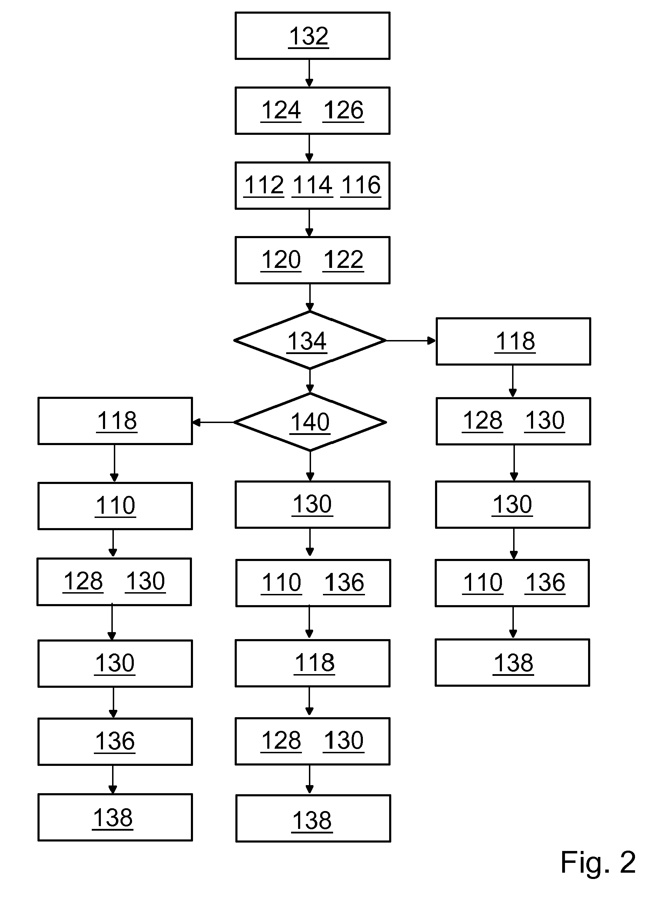

Die Hausgeräteplatte ist von einer Rohplatte 10 ausgehend mittels eines Verfahrens hergestellt, dessen Ablaufdiagramm in Fig. 2 gezeigt ist. Als Ergebnis des Herstellverfahrens sind die vier Stirnflächen 30 der Grundplatte 26 jeweils unbeschichtet. Ferner weist die Schicht 29 einen sich über die gesamte Schicht 29 erstreckenden Teilbereich 36 auf, der einer Wärmebehandlung 110 unterzogen ist. Des Weiteren weist die Grundplatte 26 wesentliche permanente thermisch induzierte mechanische Spannungen auf. Die Schicht 29 sowie die Schutzschicht 60 weisen in Teilbereichen 32 entlang der vier Kanten der Unterseite 58 der Grundplatte 26 wesentliche, von wenigstens einer Volumenbehandlung 128 und/oder einem Zuschnitt 118 der Rohplatte 10 herrührende mechanische Beschädigungen auf. Bei den Beschädigungen handelt es sich insbesondere um Absplitterungen und/oder Rissbildungen.

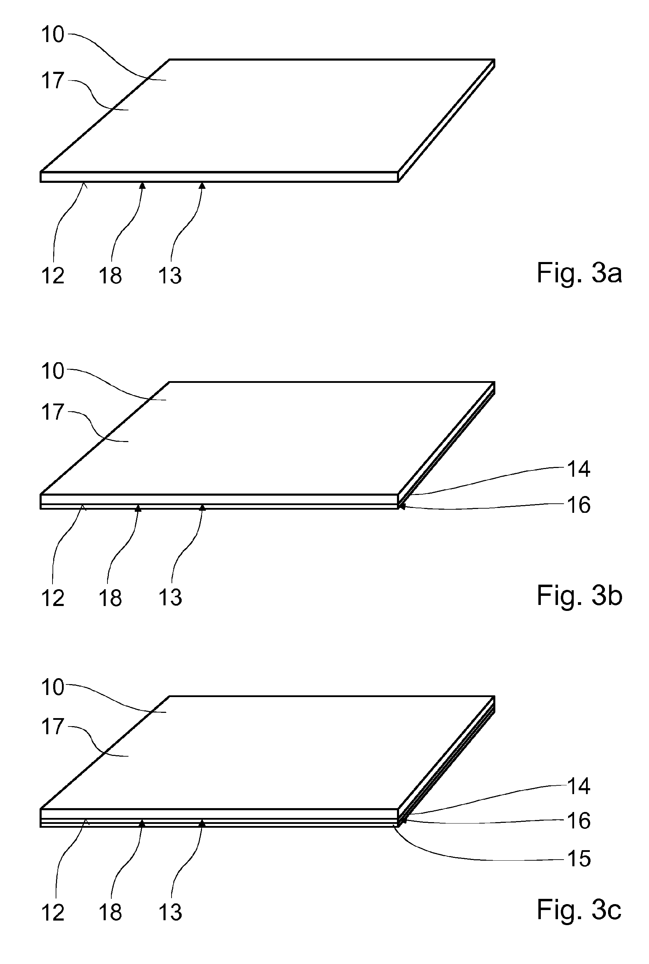

Gemäß dem in Fig. 2 gezeigten Verfahren wird in einem Vorbereitungsschritt 132 die gläserne Rohplatte 10 bereitgestellt und gereinigt. Die Rohplatte 10 liegt in einer typischen, insbesondere kommerziell erhältlichen, Größe vor, beispielsweise mit den Maßen 5 m × 5 m oder 3 m × 3 m (vgl. Fig. 3a). Bei der Rohplatte 10 handelt es sich um unbehandeltes Glas, welches insbesondere durch Walzen eines Glasbands aus einer Glasschmelze und anschließendem Zuschnitt des Glasbands hergestellt ist. Bei der Rohplatte 10 handelt es sich insbesondere um ein sogenanntes Grünglas, welches mittels einer speziellen Wärmebehandlung 110 in eine Glaskeramik überführbar ist.

Dann wird ein sich über eine gesamte Unterseite 13 der Rohplatte 10 erstreckender Teilbereich 18 der Rohplatte 10 einer Oberflächenbehandlung 126 unterzogen (vgl. Fig. 3a). Die Oberflächenbehandlung 126 dient einer speziellen optischen Ausgestaltung der Rohplatte 10. Als Oberflächenbehandlungen 126 kommen eine Laserbearbeitung, insbesondere eine Laserablation, ein Bürsten, ein abrasives Strahlen und/oder eine Säurebehandlung in Frage. Bei der Laserbearbeitung, insbesondere der Laserablation, werden in der Unterseite 13 Furchen eingebracht, wodurch eine Anmutung einer gebürsteten Oberfläche erzielt werden kann. Dabei kann eine Länge, Orientierung, Dichte und Breite der Furchen genau kontrolliert werden. Einen ähnlichen Eindruck erhält man beim Bürsten der Unterseite 13. Hier ist jedoch eine hundertprozentige Reproduzierbarkeit nicht gegeben. Beim abrasiven Strahlen können verschiedene Varianten zum Einsatz kommen, insbesondere Sandstrahlen und/oder Glasperlenstrahlen und/oder Schleuderradstrahlen und/oder Wasserstrahlen und/oder Mikrostrahlen. Ihnen ist gemein, dass sie einen Eindruck einer gefrorenen Oberfläche erzeugen können. Insbesondere ist das abrasive Strahlen zu einem Reinigen der Oberfläche vor einer Oberflächenbeschichtung 112 und/oder zu einem Aufrauen einer glatten Oberfläche und/oder zu einem Glätten einer rauen Oberfläche und/oder zu einer Formung einer Oberfläche geeignet. Der Eindruck einer gefrorenen Oberfläche kann besonders vorteilhaft durch Schleuderradstrahlen erzeugt werden. Bei der Säurebehandlung wird die Unterseite 13 einer Säure ausgesetzt, wodurch ein Staubeffekt und/oder Nebeleffekt erzielt werden kann. Alternativ oder zusätzlich ist eine Volumenbehandlung 124 denkbar, beispielsweise ein Vorsehen von Bohrungen für Halterungen und/oder Sensorelemente und/oder eine Laserbearbeitung, insbesondere eine Laserinnengravur, eines Innenbereichs der Rohplatte 10.

In einem folgenden Schritt wird ein mit dem Teilbereich 18 identischer Oberflächenteilbereich 12 der Rohplatte 10 der Oberflächenbeschichtung 112 unterworfen. Der Oberflächenteilbereich 12 wird mit einer metallischen Schicht 14 mittels einer physikalischen Gasphasenabscheidung 114, und zwar einer Kathodenzerstäubung 116 beschichtet (vgl. Fig. 3b). Die Schicht 14 wird mit einer Dicke von ungefähr 10 nm aufgetragen.

Anschließend wird ein sich über die gesamte Schicht 14 erstreckender Teilbereich 16 der Schicht 14 einer Oberflächenbehandlung 122 ausgesetzt. Bei der Oberflächenbehandlung 122 kann eine Laserbearbeitung, insbesondere eine Laserablation, durchgeführt werden, um Bereiche der metallischen Schicht 14 elektrisch gegeneinander zu isolieren. So kann durch die Laserbestrahlung einerseits eine chemische Reaktion ausgelöst werden, die zu einer Bildung eines Isolators aus dem Material der Schicht 14 führt. Alternativ kann durch die Laserablation Material der Schicht 14 abgetragen werden, insbesondere in Form von Linien und/oder Kreisbögen und/oder geschlossenen Konturen, insbesondere Rechtecke und/oder Kreise. Ferner können durch die Laserbearbeitung, insbesondere die Laserablation, bestimmte optische Effekte erzielt werden, insbesondere ein Anmutung wie gebürstetes Metall. Insbesondere kann ein Spiegelglanz der metallischen Schicht 14 reduziert werden. Durch die Laserbearbeitung, insbesondere die Laserablation, kann auch eine Kennzeichnung von Funktionszonen, insbesondere von Heizzonen und/oder Berühroberflächen und/oder Anzeigeelementen, vorgenommen werden. Ferner wird bei der Oberflächenbehandlung 122 eine Oberflächenbeschichtung der Schicht 14 mit einer dielektrischen Schutzschicht 15 vorgenommen (vgl. Fig. 3c). Durch eine entsprechende Farbgebung der Schutzschicht 15 können in einem Zusammenwirken mit der teilweise abgetragenen Schicht 14 spezielle optische Effekte erzielt werden. So kann insbesondere eine Kennzeichnung von Funktionszonen farblich variiert werden. Bei einer dickeren Schicht 14 kann an dieser Stelle alternativ oder zusätzlich eine Volumenbehandlung 120 vorgesehen sein.

Bei einer folgenden Verzweigung 134 verzweigt sich das Verfahren zur Herstellung der Hausgeräteplatte in Abhängigkeit von mechanischen Eigenschaften der Rohplatte 10.

Falls die Rohplatte 10 nach einer Wärmebehandlung 110 noch mechanisch bearbeitbar ist, gibt es zwei Varianten des Verfahrens (Verzweigung 140): eine erste Variante für einen während der Wärmebehandlung eingesetzten Keramisierungsofen, der kleiner ist als die Rohplatte 10, und eine zweite Variante für einen Keramisierungsofen, welcher groß genug ist für die Rohplatte 10.

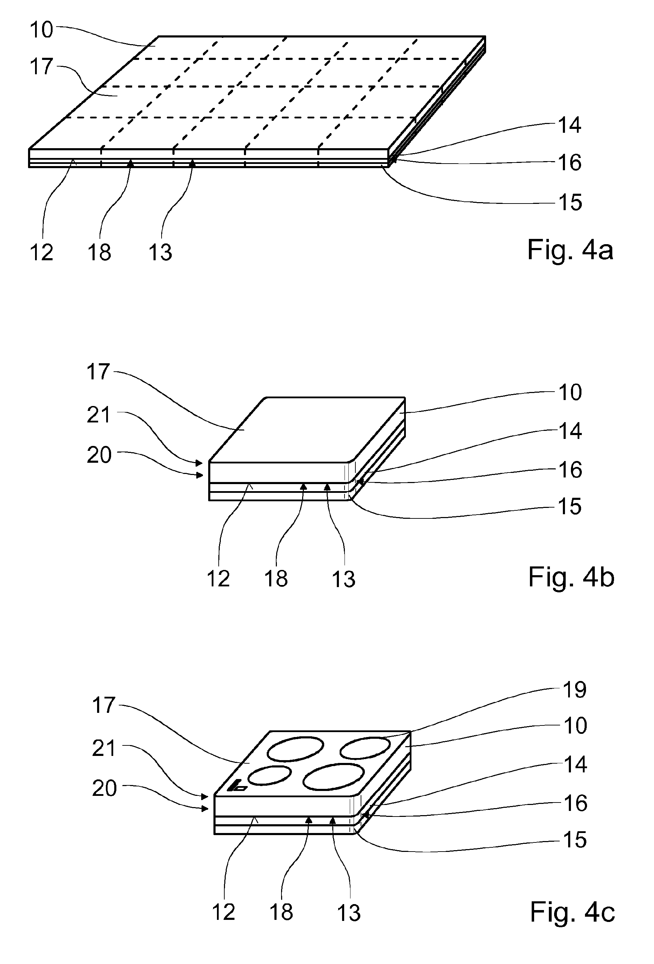

In der ersten Variante fährt das Verfahren mit einem Zuschnitt 118 der Rohplatte 10 in eine Vielzahl einzelner gleich großer Stücke fort (vgl. Fig. 4a). Eine Größe der Stücke entspricht im Wesentlichen einer Größe der Kochfeldplatte 22. Während des Zuschnitts 118 schützt die Schutzschicht 15 die Schicht 14. Dennoch sind geringfügige Beschädigungen wie die in Fig. 1 b im Teilbereich 32 gezeigten unvermeidbar.

In einem folgenden Schritt erfolgt die Wärmebehandlung 110 eines Teilbereichs 21 der zugeschnittenen Rohplatte 10 zur Umwandlung der zugeschnittenen Rohplatte 10 in eine Glaskeramik. Der Teilbereich 21 erstreckt sich über die gesamte zugeschnittene Rohplatte 10, die als Ganzes im Keramisierungsofen der Wärmebehandlung 110 unterzogen wird. Bei der Wärmebehandlung 110 handelt es sich um ein an sich bekanntes Verfahren zur Herstellung einer Glaskeramik aus einem Grünglas.

Anschließend erfolgt eine Volumenbehandlung 128 eines Teilbereichs 20 der zugeschnittenen Rohplatte 10. Im vorliegenden Fall besteht die Volumenbehandlung 128 in einem Abrunden von Ecken der zugeschnittenen Rohplatte 10 (vgl. Fig. 4b). Alternativ oder zusätzlich kann die Oberseite 17 facettiert werden. Ferner ist eine zusätzliche Oberflächenbehandlung 130 denkbar, beispielsweise eine Politur.

Anschließend erfolgt eine Oberflächenbehandlung 130 einer der Unterseite 13 gegenüberliegenden Oberseite 17 der zugeschnittenen Rohplatte 10. Auf die Oberseite 17 wird in bekannter Weise mittels eines Siebdruckverfahrens ein Glasfluss 19 aufgebracht, welcher Funktionselemente, insbesondere Heizzonen und/oder Berühroberflächen und/oder Anzeigeelemente, markiert und/oder eine Dekoration bereitstellt (vgl. Fig. 4c).

In einem folgenden Schritt erfolgt ein Einbrand 136 des Glasflusses 19 in einem entsprechenden Ofen. Das Verfahren endet für die erste Variante mit einer Endabnahme 138 der Hausgeräteplatte.

Alternativ kann ein Aufbringen des Glasflusses 19 auch unmittelbar nach dem Zuschnitt 118 erfolgen und ein Einbrand 136 des Glasflusses 19 gleichzeitig mit der Wärmebehandlung 110 der zugeschnittenen Rohplatte 10 im Keramisierungsofen.

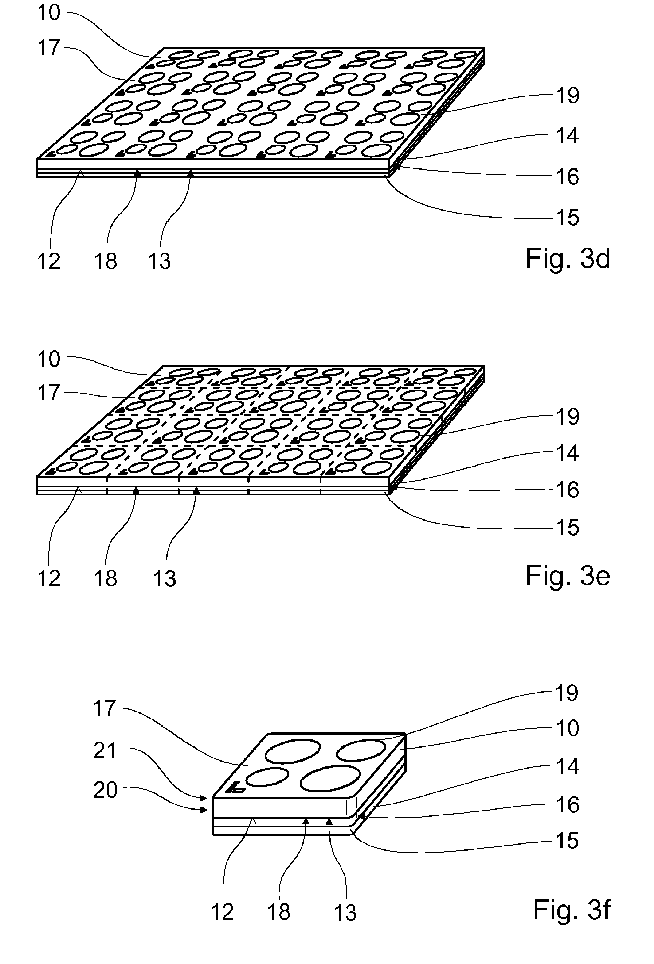

In der zweiten Variante fährt das Verfahren nach der Verzweigung 140 mit einer Oberflächenbehandlung 130 einer der Unterseite 13 gegenüberliegenden Oberseite 17 der Rohplatte 10 fort. Auf die Oberseite 17 wird in bekannter Weise mittels eines Siebdruckverfahrens ein Glasfluss 19 aufgebracht, welcher Funktionselemente, insbesondere Heizzonen und/oder Berühroberflächen und/oder Anzeigeelemente, markiert und/oder eine Dekoration bereitstellt (vgl. Fig. 3d). Da aus einer Rohplatte 10 mehrere Grundplatten 26 für mehrere Kochfeldplatten 22 gefertigt werden, wird der Glasfluss 19 zeilen- und spaltenweise aufgebracht.

In einem folgenden Schritt erfolgt die Wärmebehandlung 110 eines Teilbereichs 21 der Rohplatte 10 zur Umwandlung der Rohplatte 10 in eine Glaskeramik. Der Teilbereich 21 erstreckt sich über die gesamte Rohplatte 10, die als Ganzes im Keramisierungsofen der Wärmebehandlung 110 unterzogen wird. Bei der Wärmebehandlung 110 handelt es sich um ein an sich bekanntes Verfahren zur Herstellung einer Glaskeramik aus einem Grünglas. Gleichzeitig zur Keramisierung der Rohplatte 10 findet ein Einbrand 136 des Glasflusses 19 statt.

Anschließend erfolgt ein Zuschnitt 118 der Rohplatte 10 in eine Vielzahl einzelner gleich großer Stücke (vgl. Fig. 3e). Eine Größe der Stücke entspricht im Wesentlichen einer Größe der Kochfeldplatte 22. Während des Zuschnitts 118 schützt die Schutzschicht 15 die Schicht 14. Dennoch sind geringfügige Beschädigungen wie die in Fig. 1 b im Teilbereich 32 gezeigten unvermeidbar.

Nach dem Zuschnitt 118 erfolgt eine Volumenbehandlung 128 eines Teilbereichs 20 der zugeschnittenen Rohplatte 10. Im vorliegenden Fall besteht die Volumenbehandlung 128 in einem Abrunden von Ecken der zugeschnittenen Rohplatte 10 (vgl. Fig. 3f). Alternativ oder zusätzlich kann die Oberseite 17 facettiert werden. Ferner ist eine zusätzliche Oberflächenbehandlung 130 denkbar, beispielsweise eine Politur. Das Verfahren endet für die zweite Variante mit einer Endabnahme 138 der Hausgeräteplatte.

Falls die Rohplatte 10 nach der Wärmebehandlung 110 nicht mehr mechanisch bearbeitbar ist, beispielsweise im Fall von Borosilikatglas, fährt das Verfahren nach der Verzweigung 134 mit einem Zuschnitt 118 der Rohplatte 10 in eine Vielzahl einzelner gleich großer Stücke fort (vgl. Fig. 4a). Eine Größe der Stücke entspricht im Wesentlichen einer Größe der Kochfeldplatte 22. Während des Zuschnitts 118 schützt die Schutzschicht 15 die Schicht 14. Dennoch sind geringfügige Beschädigungen wie die in Fig. 1 b im Teilbereich 32 gezeigten unvermeidbar.

Nach dem Zuschnitt 118 erfolgt eine Volumenbehandlung 128 eines Teilbereichs 20 der zugeschnittenen Rohplatte 10. Im vorliegenden Fall besteht die Volumenbehandlung 128 in einem Abrunden von Ecken der zugeschnittenen Rohplatte 10 (vgl. Fig. 4b). Alternativ oder zusätzlich kann die Oberseite 17 facettiert werden. Ferner ist eine zusätzliche Oberflächenbehandlung 130 denkbar, beispielsweise eine Politur.

Anschließend erfolgt eine Oberflächenbehandlung 130 einer der Unterseite 13 gegenüberliegenden Oberseite 17 der zugeschnittenen Rohplatte 10. Auf die Oberseite 17 wird in bekannter Weise mittels eines Siebdruckverfahrens ein Glasfluss 19 aufgebracht, welcher Funktionselemente, insbesondere Heizzonen und/oder Berühroberflächen und/oder Anzeigeelemente, markiert und/oder eine Dekoration bereitstellt (vgl. Fig. 4c).

In einem folgenden Schritt erfolgt die Wärmebehandlung 110 eines Teilbereichs 21 der zugeschnittenen Rohplatte 10 zur Umwandlung der zugeschnittenen Rohplatte 10 in eine Glaskeramik. Der Teilbereich 21 erstreckt sich über die gesamte zugeschnittene Rohplatte 10, die als Ganzes in einem Keramisierungsofen der Wärmebehandlung 110 unterzogen wird. Bei der Wärmebehandlung 110 handelt es sich um ein an sich bekanntes Verfahren zur Herstellung einer Glaskeramik aus einem Grünglas. Gleichzeitig zur Keramisierung der zugeschnittenen Rohplatte 10 findet ein Einbrand 136 des Glasflusses 19 statt. Auch hier endet das Verfahren mit einer Endabnahme 138 der Hausgeräteplatte.

Alternativ kann auf einen Glasfluss zur Markierung von Funktionszonen und/oder zum Bereitstellen einer Dekoration einer Hausgeräteplatte auch komplett verzichtet werden. Stattdessen kann eine Markierung und/oder eine Dekoration lediglich durch eine Laserablation einer Schicht vorgenommen werden. Im Zusammenwirken mit einer als Farbschicht ausgebildeten Schutzschicht kann so auch eine farbliche Kennzeichnung erfolgen. Das erfindungsgemäße Verfahren ist insbesondere auch auf Hausgeräteplatten übertragbar, welche aus Rohplatten hergestellt sind, die aus anderen Materialien bestehen.

### Bezugszeichen

- 10: Rohplatte
- 12: Oberflächenteilbereich
- 13: Unterseite
- 14: Schicht
- 15: Schutzschicht
- 16: Teilbereich
- 17: Oberseite
- 18: Teilbereich
- 19: Glasfluss
- 20: Teilbereich
- 21: Teilbereich
- 22: Kochfeldplatte
- 26: Grundplatte
- 28: Oberflächenteilbereich
- 29: Schicht
- 30: Stirnfläche
- 32: Teilbereich
- 34: Kochfeld
- 36: Teilbereich
- 38: Markierung
- 40: Heizzone
- 42: Heizzone
- 44: Heizzone
- 46: Heizzone
- 48: Oberseite
- 50: Berühroberfläche
- 52: Anzeigeeinheit
- 54: Bedien- und Anzeigeeinheit
- 56: Schichtsystem
- 58: Unterseite
- 60: Schutzschicht
- 62: Teilstück
- 64: Teilstück
- 66: Isolierbereich
- 68: Isolierbereich
- 110: Wärmebehandlung
- 112: Oberflächenbeschichtung
- 114: physikalische Gasphasenabscheidung
- 116: Kathodenzerstäubung
- 118: Zuschnitt
- 120: Volumenbehandlung
- 122: Oberflächenbehandlung
- 124: Volumenbehandlung
- 126: Oberflächenbehandlung
- 128: Volumenbehandlung
- 130: Oberflächenbehandlung
- 132: Vorbereitungsschritt
- 134: Verzweigung
- 136: Einbrand
- 138: Endabnahme
- 140: Verzweigung

## Patentansprüche

1. Verfahren zur Herstellung einer Hausgeräteplatte, bei dem wenigstens ein Teilbereich (21) einer Rohplatte (10) einer Wärmebehandlung (110) unterzogen wird, **dadurch gekennzeichnet, dass** vor der Wärmebehandlung (110) eine Oberflächenbeschichtung (112) zumindest eines Oberflächenteilbereichs (12) der Rohplatte (10) mit einer Schicht (14) mittels einer physikalischen Gasphasenabscheidung (114) durchgeführt wird.

2. Verfahren nach Anspruch 1, **dadurch gekennzeichnet, dass** die Schicht (14) durch eine Kathodenzerstäubung (116) aufgebracht wird.

3. Verfahren nach Anspruch 1 oder 2, **dadurch gekennzeichnet, dass** nach der Oberflächenbeschichtung (112) des Oberflächenteilbereichs (12) ein Zuschnitt (118) der Rohplatte (10) auf eine gewünschte Größe vorgenommen wird.

4. Verfahren zumindest nach Anspruch 3, **dadurch gekennzeichnet, dass** zumindest ein Teilbereich (16) der Schicht (14) vor dem Zuschnitt (118) der Rohplatte (10) wenigstens einer Volumenbehandlung (120) und/oder wenigstens einer Oberflächenbehandlung (122) ausgesetzt wird.

5. Verfahren nach einem der vorhergehenden Ansprüche, **dadurch gekennzeichnet, dass** zumindest ein Teilbereich (18) der Rohplatte (10) vor der Oberflächenbeschichtung (112) des Oberflächenteilbereichs (12) wenigstens einer Volumenbehandlung (124) und/oder wenigstens einer Oberflächenbehandlung (126) ausgesetzt wird.

6. Verfahren nach einem der vorhergehenden Ansprüche, **dadurch gekennzeichnet, dass** wenigstens ein Teilbereich (20) der Rohplatte (10) nach der Oberflächenbeschichtung (112) des Oberflächenteilbereichs (12) wenigstens einer Volumenbehandlung (128) und/oder wenigstens einer Oberflächenbehandlung (130) ausgesetzt wird.

7. Hausgeräteplatte, insbesondere Kochfeldplatte (22), welche eine Grundplatte (26) und eine an wenigstens einem Oberflächenteilbereich (28) der Grundplatte (26) angeordnete Schicht (14) umfasst und welche durch ein Verfahren nach einem der vorhergehenden Ansprüche hergestellt ist.

8. Hausgeräteplatte nach Anspruch 7, **dadurch gekennzeichnet, dass** wenigstens eine Stirnfläche (30) der Grundplatte (26) unbeschichtet ist.

9. Hausgeräteplatte nach Anspruch 7 oder 8, **dadurch gekennzeichnet, dass** wenigstens ein Teilbereich (36) der Schicht (14) einer Wärmebehandlung (110) unterzogen ist und/oder die Grundplatte (26) zumindest wesentliche permanente thermisch induzierte mechanische Spannungen aufweist.

10. Hausgerät, insbesondere Kochfeld (34), mit einer Hausgeräteplatte nach einem der Ansprüche 7 bis 9.
